# EUROPEAN PATENT APPLICATION

(11) **EP 1 493 839 A1**
(43) Date of publication of application: **05.01.2005**
(21) Application number: 03745987.2
(22) Date of filing: 09.04.2003
(51) Int. Cl.: C23C 16/505, C08J 7/00, B65D 23/02, B65D 23/08

(54) **PLASMA CVD FILM FORMING APPARATUS AND METHOD FOR MANUFACTURING CVD FILM COATING PLASTIC CONTAINER**

(30) Priority: 11.04.2002 JP 2002109547
(71) Applicant: MITSUBISHI SHOJI PLASTICS CORPORATION, Shinagawa-ku, Tokyo 141-8535 (JP); Youtec Co. Ltd., Nagareyama-shi, Chiba 270-0156 (JP)
(72) Inventor: HAMA, Kenichi, C/O MITSUBISHI SHOJI PLASTICS CORP., Tokyo 141-8535 (JP); KAGE, Tsuyoshi, C/O MITSUBISHI SHOJI PLASTICS CORP, Tokyo 141-8535 (JP); TAKEMOTO, Keishu, C/O MITSUBISHI SHOJI PLAST. CORP, Tokyo 141-8535 (JP); KOBAYASHI, Takumi, C/O YOUTEC CO., LTD, Nagareyama-shi, Chiba 270-0156 (JP)
(74) Representative: Bunke, Holger, Dr.rer.nat. Dipl.-Chem.
(86) International application number: PCT/JP2003/004530
(87) International publication number: WO 2003/085165

(57) **Abstract**

The restriction that the outer electrode of a conventional CVD film forming apparatus has to have a hollow structure including a hollow which is for accommodating a container and has a shape generally similar to the outer shape of the container is eliminated. A plasma CVD film forming apparatus is characterized in that a container outside gas is supplied into the space defined between the inner wall of an outer electrode and the outer surface of a container spaced from the inner wall, the plasma thereby produced from the container outside gas in forming a film by CVD serves as a conductor and transmits high-frequency to the outer wall of the container, a state is brought about in which the inner wall of the outer electrode is equivalently in contact with the outer surface of the plastic container, and a uniform self-bias voltage is applied to the inner wall of the container.

## Description

### Technical Field

The present invention relates to a plasma CVD film forming apparatus for coating a CVD film, in particular, a DLC (Diamond Like Carbon) film on at least one of an inner surface and an outer surface of a plastic container by using a CVD (Chemical Vapor Deposition, chemical vapor growing method) method, and the present invention further relates to a method for manufacturing a CVD film coated plastic container.

### Background Art

Japanese Patent Application Laid-Open No. 8-53117 discloses, for example, a vapor deposition apparatus which uses a CVD (Chemical Vapor Deposition, chemical vapor growing method) method, in particular, a plasma CVD method for vapor depositing a DLC (Diamond Like Carbon) film on an inner surface of a plastic container for the purpose of improving the gas barrier properties and the like. Further, Japanese Patent Application Laid-Open No. 10-258825 discloses a manufacturing apparatus for mass generating a DLC film coated plastic container and a method for manufacturing the same. Further, Japanese Patent Application Laid-Open No. 10-226884 discloses an apparatus for manufacturing a DLC film coated plastic container capable of coating the DLC film without mottling to a container having protrusions which protrude from the outer surface to the outside and a method for manufacturing the same.

In the above-described publications, an external electrode has a hollow shape formed to house a container, the hollow shape having a free space which is substantially similar to an external shape of the container to be accommodated. That is, there has been a need to process an inner wall face of a free space of an external electrode such that the whole outer wall face of the plastic container substantially comes into planar contact with an inner wall face of a free space of the external electrode. A reason why an inner wall face of a free space of the external electrode substantially comes into planar contact with the entire of the outer wall face of the plastic container is that a self bias voltage is uniformly applied to the inner wall face of the plastic container. If there is a portion at which the inner wall face of the external electrode and the outer wall face of the plastic container are spaced from each other, no self bias voltage is applied to the spaced portion of the inner wall face of the plastic container. Therefore, a source gas based plasma ion does not collide with the inner wall face of the container strongly during plasma fire ignition, no fine DLC film can be obtained, and a film quality becomes uniform. Further, when the inner wall face of the external electrode and the whole outer wall face of the plastic container are spaced from each other, a bias voltage is not applied to the inner wall face of the container, and even if a uniform film is deposited, such a film is not obtained as a fine DLC film. If no fine DLC film can be obtained, sufficient gas barrier properties cannot be obtained.

In the above-described publications, the internal electrode is compatible with a pipeline for introducing a source gas, and is grounded. This internal electrode is formed in a pipeline shape having a source gas supply port at a distal end.

As described above, the outer wall face of the container and the inner wall face of the external electrode cannot be brought into planer contact with each other with respect to a container having a plenty of irregularities such as a heat insulation type container, and it is difficult to achieve sufficient gas barrier properties. In addition, gas interruption properties are improved by using an external electrode along the shape of the container. However, there is a need to make a design for forming the external electrode in a split pattern, and there is a need to provide the split pattern for each bottle shape.

### Disclosure of Invention

The present invention has been achieved to solve a problem which occurs in an external electrode of a conventional film forming apparatus because there is a restriction on a shape of an inner wall face of a free space of the external electrode. That is, it is an object of the present invention to provide a plasma CVD film forming apparatus for supplying a container external gas in a space generated by spacing an inner wall face of an external electrode and an outer surface of the container from each other, whereby the container external gas generated as a plasma during CVD film forming is obtained as an electrically conducting body to conduct a high frequency on the outer wall face of the container, and generating a state approximate to a state in which the inner wall face of the external electrode comes into planar contact with the outer surface of the plastic container, thereby making it possible to apply a uniform self bias voltage to the inner wall face of the container. That is,.it is an object of the present invention to provide a plasma CVD film forming apparatus capable of forming a uniform and fine CVD film on a wall face of the container by introducing a container external gas. In addition, according to this plasma CVD film forming apparatus, it is an object of the present invention to make a container internal gas or a container external gas selectable for a source gas or a discharge gas, thereby making it possible to form CVD films on only the inner surface of the container, the outer surface of the container, or both of the inner and outer surfaces of the container. Further, in the case where a container internal gas or a container external gas has been generated as a discharge gas, it is an object of the present invention to make it possible to reform a plasma surface on the wall face of the plastic container by using a discharge gas generated as a plasma.

Furthermore, it is an object of the present invention to provide a plasma CVD film forming apparatus for forming a free space of an external electrode in a shape having a portion spaced from an outer surface of the plastic container when the plastic container is accommodated, thereby making it possible to form a CVD film so as to be associated with each of the plastic containers of a plenty of types by using one type of external electrode. That is, the shape of the inner wall face shape of the external electrode must not depend on the shape of the outer surface of the container.

It is an object of the present invention to provide a plasma CVD film forming apparatus for forming a free space of an external electrode in a shape having an inner wall face which comes into contact along the shape of a bottom part of a plastic container when the plastic container is accommodated, thereby directly supplying a high frequency from the external electrode to the bottom part of the plastic container and supplying a high frequency to a portion other than the bottom part of the plastic container while the container external gas generated as a plasma is used as a transmission medium. In this manner, there is provided an advantage that the shape of the free space of the external electrode does not depend on the shape of the container while the gas barrier properties of the bottom part of the container are sufficiently maintained. In addition, it is an object of the present to prevent the external electrode from being large-sized in a longitudinal direction of the container.

Moreover, it is an object of the present invention to form a free space of the external electrode in a shape having an inner wall face which comes into contact along the shapes of the bottom part and body part of the plastic container when the plastic container is accommodated, thereby providing an advantage that the shape of the free space of the external electrode does not depend on the shape of the container while the gas barrier properties of the bottom part and body part of the container are sufficiently maintained.

In addition, according to the apparatus of the present invention, in the case where a CVD film formed at the bottom part and body part of the container or at the bottom part of the container becomes thicker than other portion of the container, it is an object of the present invention to set the inner wall face of the external electrode which comes into contact with the other portion to an insulated state from high frequency power such that a low self bias voltage is applied to the bottom part and body part of the container or to the bottom part of the container, thereby making a film thickness distribution uniform.

The apparatus of the present invention generates a high frequency power conducting body by generating the container external gas as a plasma at the outside of the container. In this system, an electric field in the vicinity of the internal electrode becomes strong, and a plasma power discharge inside of the container becomes strong. On the other hand, there can occur a case in which an electric field is weak at the outside of the container, and external power discharge is not sufficient depending on the shape of the container. Therefore, it is an object of the present invention to provide magnetic field generating means at the periphery of the outer wall face of the external electrode, thereby increasing a plasma density at the outside of the container even in such a case. It is an object of the present invention to generate the magnetic field generating means, thereby ensuring improvement of a velocity of CVD film forming on the outer surface of the container or surface modifying and improvement of the outer surface of the container. Further, it is an object of the present invention to increase a plasma density at the inside of the container, thereby ensuring improvement of the velocity of CVD film forming on the inner surface of the container or surface modifying and improvement of the inner surface of the container.

Furthermore, it is an object of the present invention to provide a plasma CVD film forming apparatus capable of forming CVD films on a plurality of plastic containers based on a power discharge scheme of the present invention at the same time.

It is an object of the present invention to provide a CVD film coated plastic container manufacturing apparatus for forming a CVD film on an inner surface of a plastic container and carrying out plasma surface modifying such as static electricity proofing on an outer surface of the plastic container or improvement of applicability to outer face printing.

In addition, it is an object of the present invention to provide a CVD film coated plastic container manufacturing method for forming a CVD film on an outer surface of a plastic container and carrying out plasma surface modifying such as sterilization of an inner surface of the plastic container or improvement of wetting properties.

Further, it is an object of the present invention to provide a CVD film coated plastic container manufacturing method for forming CVD films on an inner surface and an outer surface of the plastic container at the same time.

It is an object of the present invention to provide a CVD film coated plastic container manufacturing method capable of forming a CVD film with its sufficient gas barrier properties for a plastic container whose neck part, shoulder part, and body part are formed in their complicated shapes and forming a CVD film in a stable manner without depending on a state in which a container external gas is generated as a plasma at the bottom part. Further, it is an object of the present invention to provide a CVD film coated plastic container manufacturing method capable of forming a fine CVD film with its sufficient gas barrier properties for a plastic container whose neck part and shoulder part are formed in their complicated shapes and forming a CVD film in a stable manner without depending on a state in which a container external gas is generated as a plasma at the bottom part and body part.

In addition, according to the manufacturing method of the present invention, it is an object to set an inner wall face of an external electrode which comes into contact with the portion to an insulated state from high frequency power such that a low self bias voltage is applied to the bottom part and body part of the container or to the bottom part of the container, thereby making a film thickness distribution uniform.

It is an object of the present invention to provide a CVD film coated plastic container manufacturing method capable of forming CVD films at least on the inner surfaces or outer surfaces of a plurality of plastic containers at the same time.

Further, it is an object of the present invention to provide a DLC film coated plastic container manufacturing method in a CVD film coated plastic container manufacturing method of the present invention.

The inventors made utmost effort for research and development in order to solve restriction that an external electrode of a conventional CVD film forming apparatus must be formed in a hollow shape formed to house a container, the hollow shape having a free space which is substantially similar to the external shape of the container to be accommodated. Then, the inventors introduced a source gas or discharge gas generated as a plasma to form a power conducting body into a sealed space formed by spacing of an inner wall face of an external electrode from an outer wall face of a container, whereby it was found out to attain advantageous effect similar to that caused by the inner wall face of the external electrode and the outer wall face of the container coming into contact with each other. In addition, the inventors employed this film forming system, whereby it was found out to enable addition of a new function over a conventional apparatus, and completed the present invention.

That is, a plasma CVD film forming apparatus of the present invention is characterized by comprising: an external electrode being compatible with a vacuum chamber having a free space for accommodating a plastic container, the vacuum chamber being capable of accommodating the plastic container in the free space such that a container internal gas and a container external gas of the plastic container are not mixed with each other; an internal electrode removably disposed at the inside of the plastic container in an insulated state from the external electrode; container internal gas introducing means for introducing the container internal gas which is a source gas or a discharge gas to be generated as a plasma into the inside of the plastic container; container external gas introducing means for introducing the container external gas which is a source gas or a discharge gas to be generated as a plasma into a sealed space which is the free space; and high frequency supply means for supplying a high frequency to the external electrode.

A plasma CVD film forming apparatus of the present invention is characterized by comprising: an external electrode having a hollow shape with bottom having a free space for accommodating a plastic container and having an opening in the vicinity of a mouth part of the plastic container when the plastic container is accommodated; an internal electrode removably disposed at the inside of the plastic container; a cover having a mouth part opening for causing a mouth part of the plastic container to be abutted in an intimate contact state and via an insulating body such that a container internal gas and a container external gas of the plastic container are not mixed with each other when the plastic container is accommodated in the free space, the cover supporting the internal electrode such that the internal electrode is in an insulated state from the external electrode and the internal electrode passes through the mouth part opening, and further sealing the opening to form the free space as a sealed space; container internal gas introducing means for introducing the container internal gas which is a source gas or a discharge gas to be generated as a plasma into the inside of the plastic container; container external gas introducing means for introducing the container external gas which is a source gas or a discharge gas to be generated as a plasma into the sealed space formed of the external electrode and the cover; and high frequency supply means for supplying a high frequency to the external electrode.

In the plasma CVD film forming apparatus of the present invention, it is preferable that the free space of the external electrode is formed in a shape having a portion spaced from an outer surface of the plastic container when the plastic container is accommodated.

Further, in the plasma CVD film forming apparatus of the present invention, it is preferable that the free space of the external electrode is formed in a shape having an inner wall face which comes into contact along a shape of a bottom part of the plastic container when the plastic container is accommodated. The word "contact" used herein denotes a state in which a substantially planar contact is brought when a gap is equal to or smaller than 2 mm. This gap of 2 mm considers a molding error of the container or a processing error of the external electrode.

Furthermore, in the plasma CVD film forming apparatus of the present invention, it is preferable that the free space of the external electrode is formed in a shape having an inner wall face which comes into contact along shapes of a bottom part and a body part of the plastic container when the plastic container is accommodated.

In the plasma CVD film forming apparatus of the present invention, it is preferable that the inner wall face of the external electrode which comes into contact along the shape of the bottom part of the plastic container or the inner wall face of the external electrode which comes into contact along shapes of the bottom part and body part of the plastic container is established in an insulated state from the high frequency supply means.

In the plasma CVD film forming apparatus of the present invention, it is preferable that a plastic container support base comprising an insulating body which comes into contact along the shape of the bottom part of the plastic container or the shapes of the bottom part and body part of the plastic container is installed at the inside of the free space.

Further, in the plasma CVD film forming apparatus of the present invention, it is preferable that magnetic field generating means such as an inductive coil or a permanent magnet is peripherally provided on an outer wall face of the external electrode.

In the plasma CVD film forming apparatus of the present invention, it is preferable that the free space of the external electrode is formed in a shape having a space with a size capable of accommodating a plurality of plastic containers at the same time, the cover supports the internal electrode disposed at every plastic container, and the internal gas introducing means introduces the internal gas in every plastic container.

Furthermore, a method for manufacturing a CVD film coated plastic container of the present invention is characterized by comprising: in a state in which a container internal gas and a container external gas of a plastic container are not mixed with each other, accommodating the plastic container in a free space of an external electrode compatible with a vacuum chamber and disposing an internal electrode at the inside of the plastic container; replacing the inside of the plastic container with a source gas and replacing the inside of the free space with a discharge gas; and supplying a high frequency to the external electrode, generating the source gas and the discharge gas as plasmas to form a CVD film on an inner surface of the plastic container, and carrying out plasma surface modifying such as static electricity prevention of an outer surface of the plastic container or improvement of applicability to outer face printing.

A method for manufacturing a CVD film coated plastic container of the present invention is characterized by comprising: accommodating a plastic container in a free space of an external electrode having a hollow shape with bottom, and abutting a mouth part of the plastic container with a mouth part opening provided at a cover for sealing an opening of the external electrode in an intimate contact state such that a container external gas and a container internal gas are not mixed with each other, thereby forming a sealed space with the external electrode and the cover; replacing the inside of the plastic container with a source gas and replacing the inside of the sealed space with a discharge gas; and supplying a high frequency to the external electrode, generating the source gas and the discharge gas as plasmas to form a CVD film on an inner surface of the plastic container and carrying out plasma surface modifying such as prevention of static electricity on an outer surface of the plastic container or improvement of applicability to outer face printing.

Moreover, a method for manufacturing a CVD film coated plastic container of the present invention is characterized by comprising: in a state in which a container internal gas and a container external gas of a plastic container are not mixed with each other, accommodating the plastic container in a free space of an external electrode compatible with a vacuum chamber and disposing an internal electrode at the inside of the plastic container; replacing the inside of the plastic container with a discharge gas and replacing the inside of the free space with a source gas; and supplying a high frequency to the external electrode, generating the discharge gas and the source gas as plasmas to form a CVD film on an outer surface of the plastic container and carrying out plasma surface modifying such as sterilization of an inner surface of the plastic container or improvement of wetting properties.

In addition, a method for manufacturing a CVD film coated plastic container of the present invention is characterized by comprising: accommodating a plastic container in a free space of an external electrode having a hollow shape with bottom, abutting a mouth part of the plastic container with a mouth part opening provided at a cover for sealing an opening of the external electrode in an intimate contact state such that a container external gas and a container internal gas are not mixed with each other and disposing an internal electrode at the inside of the plastic container to form a sealed space with the external electrode and the cover; replacing the inside of the plastic container with a discharge gas and replacing the inside of the sealed space with a source gas; and supplying a high frequency to the external electrode, generating the discharge gas and the source gas as plasmas to form a CVD film on an outer surface of the plastic container and carrying out plasma surface modifying such as sterilization of an inner surface of the plastic container or improvement of wetting properties.

A method for manufacturing a CVD film coated plastic container of the present invention is characterized by comprising: in a state in which a container internal gas and a container external gas of a plastic container are not mixed with each other, accommodating the plastic container in a free space of an external electrode compatible with a vacuum chamber and disposing an internal electrode at the inside of the plastic container; replacing the inside of the plastic container and the inside of the free space with a source gas; and supplying a high frequency to the external electrode and generating the source gas as a plasma to form CVD films on an inner surface and an outer surface of the plastic container at the same time.

Further, a method for manufacturing a CVD film coated plastic container of the present invention is characterized by comprising: accommodating a plastic container in a free space of an external electrode having a hollow shape with bottom, abutting a mouth part of the plastic container with a mouth part opening provided at a cover for sealing an opening of the external electrode in an intimate contact state such that a container external gas and a container internal gas are not mixed with each other and disposing an internal electrode at the inside of the plastic container to form a sealed space with the external electrode and the cover; replacing the inside of the plastic container and the inside of the sealed space with a source gas; and supplying a high frequency to the external electrode and generating the source gas as a plasma to form CVD films on an inner surface and an outer surface of the plastic container at the same time.

In the method for manufacturing a CVD film coated plastic container of the present invention, it is preferable that, when a high frequency is supplied to the external electrode, a bottom part of the plastic container receives a high frequency from an inner wall face of the external electrode which comes into contact along a shape of the bottom part to generate a self bias voltage, and a neck part, a shoulder part, and a body part of the plastic container receive a high frequency when the container external gas generated as a plasma is defined as an electrically conducting body to generate a self bias voltage and to ignite plasmas as fires at the inside and outside of the plastic container.

Further, in the method for manufacturing a CVD film coated plastic container of the present invention, it is preferable that, when a high frequency is supplied to the external electrode, a bottom part and a body part of the plastic container receive a high frequency from an inner wall face of the external electrode which comes into contact along shapes of the bottom part and body part to generate a self bias voltage, and a neck part and a shoulder part of the plastic container receive a high frequency when the container external gas is defined as an electrically conducting body to generate a self bias voltage and to ignite plasmas as fires at the inside and outside of the plastic container.

In the method for manufacturing a CVD film coated plastic container of the present invention, it is preferable that an inner wall face of the external electrode which comes into contact along a shape of a bottom part of the plastic container or an internal wall face of the external electrode which comes into contact along shapes of the bottom part and body part of the plastic container is established in an insulated state from a high frequency.

In the method for manufacturing a CVD film coated plastic container of the present invention, it is preferable that an insulating body coming into contact along a shape of a bottom part of the plastic container or shapes of the bottom part and body part of the plastic container is installed at the inside of the free space, and the bottom part of the plastic container or the bottom part and body part of the plastic container are established in an insulated state from a high frequency.

In the method for manufacturing a CVD film coated plastic container of the present invention, it is preferable that, in a state in which a container internal gas and a container external gas of a plastic container are not mixed with each other, a plurality of plastic containers are accommodated in a free space of an external electrode compatible with a vacuum chamber and an internal electrode is disposed at the inside of the each plastic containers; the inside of the each plastic container is replaced with a container internal gas which is a source gas or a discharge gas and the free space is replaced with a raw material or a discharge gas; and a high frequency is supplied to the external electrode and the container internal gas and the container external gas are generated as plasmas to form CVD films on at least either of inner surfaces and outer surfaces of the plurality of plastic containers at the same time.

In the method for manufacturing a CVD film coated plastic container of the present invention, it is preferable that a plurality of plastic containers are accommodated in a free space of an external electrode having a hollow shape with bottom, a mouth part of the each plastic container is abutted with each of a plurality of mouth part openings provided at a cover for sealing an opening of the external electrode in an intimate contact state such that a container external gas and a container internal gas are not mixed with each other and an internal electrode is disposed at the inside of each of the plastic containers to form a sealed space with the external electrode and the cover; the inside of the each plastic container is replaced with a container internal gas which is a source gas or a discharge gas and the sealed space is replaced with a container external gas which is a source gas or a discharge gas; a high frequency is supplied to the external electrode, and the container internal gas and the container external gas are generated as plasmas to form CVD films on at least either of inner surfaces and outer surfaces of the plurality of plastic containers at the same time.

In the method for manufacturing a CVD film coated plastic container of the present invention, it is preferable that a hydrocarbon based gas or a Si-containing hydrocarbon based source gas is used as the source gas to form a DLC film as a CVD film.

With the CVD film forming apparatus according to the present invention, restriction on the shape of the inner wall face of a free space in the external electrode has been successfully eliminated. That is, a uniform and fine CVD film can be formed on the wall face of the container by introducing the container external gas. With this CVD film forming apparatus, by making the container internal gas or the container external gas selectable for the source gas or discharge gas, the CVD film has been successfully formed on only the container inner surface, only the container outer surface, or both of the inner surface and outer surface of the container. Further, in the case where the container internal gas or container external gas has been used as a discharge gas, plasma surface modifying on the plastic container wall face can be carried out by a discharge gas generated as a plasma. Furthermore, in a heat insulating bottle having a pressure reducing absorption face as well, film forming has been successfully carried out without worrying about a gap between the inner wall face of the external electrode and the outer wall face of the container.

In addition, the CVD film forming apparatus of the present invention can form CVD films respectively to be associated with plastic containers formed in multiple shapes by using one kind of external electrode. That is, the shape of the inner wall face of the external electrode does not depend on the shape of the outer surface of the container.

The CVD film forming apparatus of the present invention has an advantage that a free space of the external electrode is formed in a shape having an inner wall face which comes into contact along a shape of a bottom part of a plastic container when the plastic container is accommodated or is formed in a shape having an inner wall face which comes into contact along the shape of the bottom part and body part of the plastic container when the plastic container is accommodated, whereby the shape of the free space of the external electrode does not depend on the shape of the container while the gas barrier properties of the bottom part of the container is sufficiently maintained. In addition, the large scaling of the external electrode in the longitudinal direction of the container has been successfully prevented.

According to the CVD film forming apparatus of the present invention, magnetic field generating means is provided at the periphery of the outer wall face of the external electrode and the plasma density is increased, thereby making it possible to achieve the improvement of the CVD film forming velocity onto the outer surface of the container or the improvement of surface modifying on the outer surface of the container, and further, to achieve the improvement of the CVD film forming velocity onto the inner surface of the container or the improvement of surface modifying on the inner surface of the container.

The CVD film forming apparatus of the present invention can form the CVD films on a plurality of plastic containers at the same time.

With the CVD film coated plastic container manufacturing method of the present invention, the CVD film can be form on the inner surface of the plastic container and it is possible to provide plasma surface modifying such as prevention of static electricity on the outer surface of the plastic container or improvement of applicability to outer face printing.

In addition, according to the CVD film coated plastic container manufacturing method, a CVD film can be formed on an outer surface of a plastic container and plasma surface modifying such as sterilization of an inner surface of the plastic container or improvement of wetting properties can be carried out.

Further, with the CVD film coated plastic container manufacturing method of the present invention, the CVD films can be formed on the inner surface and outer surface of the plastic container at the same time.

With the CVD film coated plastic container manufacturing method of the present invention, a fine CVD film with its sufficient gas barrier properties can be formed on a plastic container whose neck part, shoulder part, and body part are formed in their complicated shapes and the CVD film can be formed at the bottom part in a stable manner without depending on a state in which the container external gas is generated as a plasma. Further, a fine CVD film with its sufficient gas barrier properties can be formed on a plastic container whose neck part and shoulder part are formed in their complicated shapes and the CVD film can be formed at the bottom part and body part in a stable shape without depending on a state in which the container external gas is generated as a plasma.

In addition, with the CVD film coated plastic container manufacturing method of the present invention, a CVD film can be formed at the same time at least one of the inner surfaces and outer surfaces of a plurality of plastic containers.

Further, the CVD film coated plastic container manufacturing method of the present invention can be applied to manufacture of a DLC film coated plastic container.

### Brief Description of Drawings

FIG. 1 is a conceptual diagram showing one embodiment of a CVD film forming apparatus according to the present invention.
FIG. 2 is a conceptual diagram showing another embodiment of the CVD film forming apparatus according to the present invention.
FIG. 3 is a conceptual diagram showing a third embodiment of the CVD film forming apparatus according to the present invention.
FIG. 4 is a conceptual view showing a specific shape of a plastic container according to the present invention, wherein (a) to (f) show four aspects.
FIG. 5 is a conceptual diagram showing a fourth embodiment of the CVD film forming apparatus according to the present invention and showing an apparatus capable of forming films on a plurality of plastic containers at the same time.
FIG. 6 is a conceptual diagram showing a fifth embodiment of the CVD film forming apparatus according to the present invention and showing a case in which a permanent magnet is peripherally provided as magnetic field generating means at the periphery of an external electrode.
FIG. 7 is a conceptual diagram showing a sixth embodiment of the CVD film forming apparatus according to the present invention and showing a case in which an inductive coil is peripherally provided as magnetic field generating means at the periphery of an external electrode.
FIG. 8 is a conceptual diagram showing a seventh embodiment of the CVD film forming apparatus according to the present invention.
FIG. 9 is a conceptual diagram showing an eighth embodiment of the CVD film forming apparatus according to the present invention.
FIG. 10 is a conceptual diagram showing a ninth embodiment of the CVD film forming apparatus according to the present invention.
FIG. 11 is a conceptual diagram showing a tenth embodiment of the CVD film forming apparatus according to the present invention.

Reference numerals in the figures are as follows. Reference numerals 1, 61, and 67 each denote a lower external electrode; 2, 60, and 66 each denote an upper external electrode; 3, 62, and 68 each denote an external electrode; 4a, 4c, 10, and 63 each denote an insulating member; 4b denotes an electrically conducting member; 5 denotes a cover; 6 denotes a film forming chamber; 7 denotes a plastic container; 8, 53, 54, 55, and 64 each denote an O-ring; 9 denotes an internal electrode; 11, 12, 13, 22, 30, 33, 36, and 41 each denote a pipeline; 14 denotes an automatic matching device (matching box); 15 denotes a high frequency power source (RF power source); 16, 17, 18, 31, 34, and 40 each denote a vacuum valve; 19 and 35 each denote a mass flow controller; 20 denotes a container internal gas generating source; 21 and 25 each denote a vacuum pump; 27 and 32 each denote a leak source; 24 and 28 each denote a vacuum gauge; 26 and 29 each denote an air exhaust duct; 37 denotes a container external gas generating source; 38 denotes container external gas introducing means; 39 denotes high frequency supply means; 41 denotes container internal gas introducing means; 49 denotes gas blow port; reference numeral 43 denotes leak means; 44 denotes air exhaust means; reference numeral 50 denotes a permanent magnet; 51 denotes an inductive coil; 56 denotes a container support device; 65 denotes elevating means; 69 denotes a container support base composed of an electrically conducting body; and 70 denotes a container support base composed of an insulating body.

### Best Mode for Carrying Out the Invention

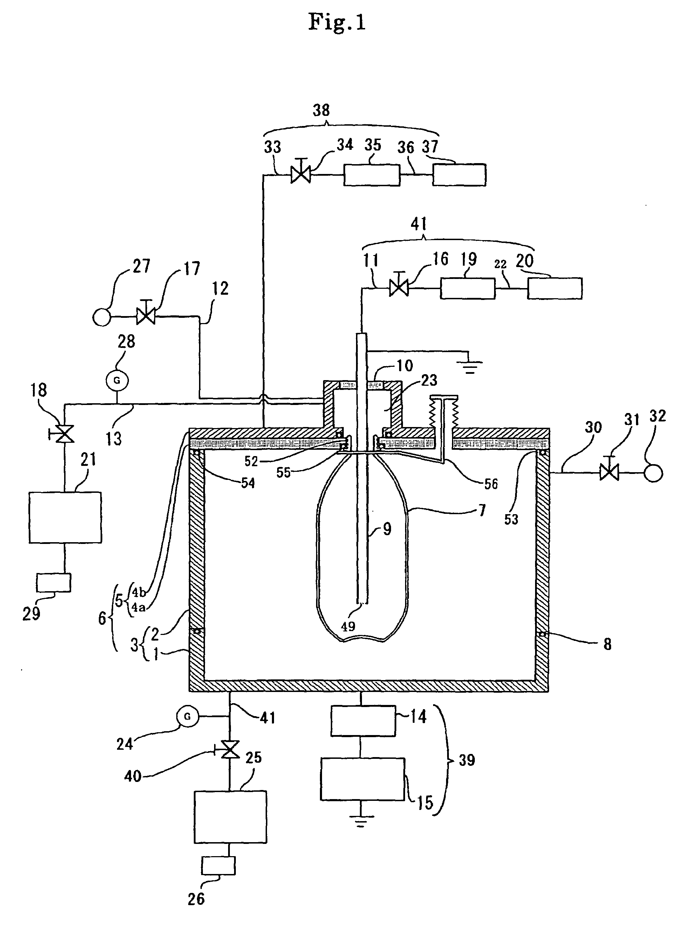

Hereinafter, the present invention will be described in detail by showing a plurality of embodiments. The present invention is not construed to be limited to these embodiments. In addition, in the drawings, like elements are designated by like reference numerals. Hereinafter, the embodiments of the present invention will be described with reference to FIG. 1 to FIG. 11.

FIG. 1 is a conceptual diagram showing a relationship in basic configuration of a CVD film forming apparatus according to the present invention. The CVD film forming apparatus according to the present invention comprises: an external electrode 3 having a hollow shape with bottom for accommodating a plastic container 7; an internal electrode 9 removably disposed at the inside of the plastic container 7; a cover 5 having a mouth part opening 52 with which a mouth part of the plastic container 7 abuts, and supporting the internal electrode 9; container internal gas introducing mean 41; container external gas introducing means 38; and high frequency supply means 39 for supplying a high frequency to the external electrode 3.

A film forming chamber 6 is composed of the external electrode 3, the internal electrode 9, and the cover 5, and forms a vacuum chamber which can be sealed.

A free space is provided at the inside of the external electrode 3. This space is provided as an accommodating space for accommodating the plastic container 7 to be coated, for example, a PET bottle which is a container made of a polyethylene terephthalate resin. Here, in the present invention, it is preferable that the free space of the external electrode 3 is formed in a shape having a portion spaced from an outer surface of the plastic container 7 when the plastic container 7 is accommodated. There is no need to form the free space of the external electrode 3 to be slightly larger than the external shape of the plastic container unlike a conventional one. That is, there is no need to form an inner wall face of a space for accommodating a container in a shape surrounding the outside vicinity of the plastic container. Therefore, the inner wall face of the space for accommodating the container and the outer wall face of the container may be partly spaced from each other or may be fully spaced from each other. If an attempt is made to apply a self bias voltage to the inner wall face of the container as in the conventional case, the inner wall face of the accommodating space and the outer wall of the container must be made close to each other. However, in the present invention, means for transmitting a high frequency is provided such that a self bias voltage is applied to a container wall face even if these faces are not made close to each other. The means is to form an electrical conducting body by generating a plasma at the outside of the container as explained later. A reason why the self bias voltage is applied is that an ion of a source gas generated as a plasma is caused to collide with the wall face of the container, and a fine CVD film is formed.

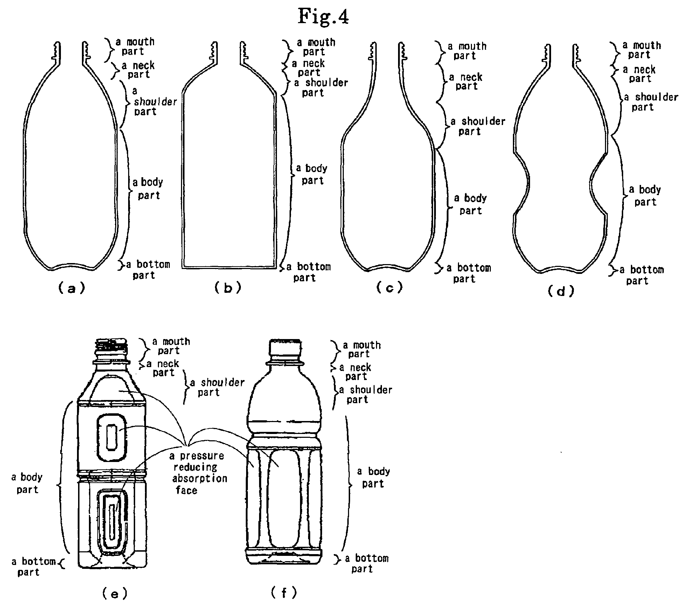

In the present invention, a gap between the inner wall face of the space for accommodating the container and the external face of the container depends on electrical conductivity of the container external gas generated as a plasma. However, for example, the gap is about 2 mm to 50 mm in a carbonated round type PET container of which the height is 207 mm, the thickness is 0.3 mm, the capacity is 500 ml, the inner surface area is 400 cm², and the diameter of the body portion is 68.5 mm (type shown in FIG. 4(a)). This value does not limit the present invention because it greatly depends on a high frequency output to be applied or the shape and size of the container and the like. However, in a conventional CVD film forming apparatus which does not introduce a container external gas generated as a plasma, in the case of film forming in a similar container, there is a need to set a gap between the inner wall face of the space for accommodating the container and the outer wall face of the container to about 1 mm or less. Thus, there is a clear difference from the CVD film forming apparatus according to the present invention. Conventionally, a gap of 1 mm or less between the inner wall face of the space for accommodating the container and the outer wall face of the container must be provided over the whole outer wall face of the container. In the present invention, a body portion of the container can eliminate a gap, and a gap can be provided at a shoulder part. That is, there is no need to form the shape of the free space of the external electrode to be similar to the external shape of the container, and the free space may be formed in a maximum shape capable of accommodating the container in various shapes.

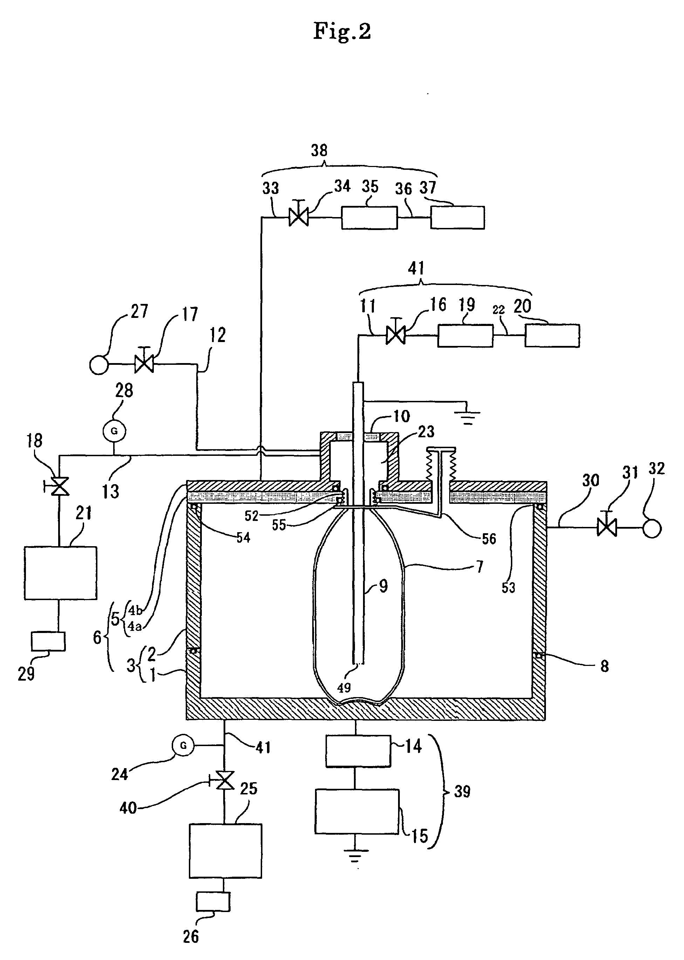

In the present invention, a bottom of the external electrode 3 may be formed in a shape shown in FIG. 2. That is, the free space of the external electrode 3 is formed in a shape having an inner wall face which comes into contact with the shape of the bottom part of the plastic container 7 when the plastic container 7 is accommodated. By forming this shape, a self bias voltage can be directly applied from the external electrode to only the bottom part of the container. Therefore, stable film forming becomes possible without depending on a plasma discharge state at the outside of the container. In addition, the size in the height direction of the film forming chamber 6 can be downsized.

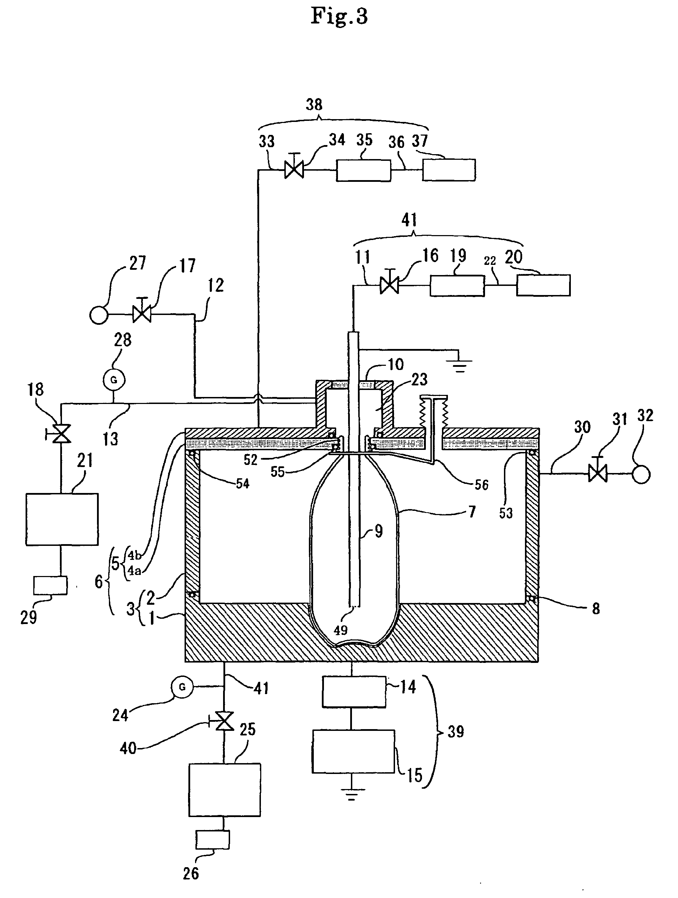

Further, in the present invention, the bottom of the external electrode 3 may be formed in a shape shown in FIG. 3. That is, the free space of the external electrode 3 is formed in a shape having the inner wall face which comes into contact along the shapes of the bottom part and body part of the plastic container 7 when the plastic container 7 is accommodated. By forming this shape, a self bias voltage can be directly applied from the external electrode to the bottom part and body part of the container. Therefore, stable film forming becomes possible without depending on the plasma discharge state at the outside of the container. In addition, the size in the height direction of the film forming chamber 6 can be downsized.

In the present invention, there can be used a container with high degree of freedom in shape, including the shape illustrated in FIG. 4. The bottom part, body part, shoulder part, and neck part of the container are called respectively together with the shape of the container as shown in FIG. 4. Therefore, these parts are not specified by the height of the container. In addition, a pressure reducing absorption face may be provided in the container. In the case where the pressure reducing absorption face has been provided, it is difficult to fully establish the inner wall face of the external electrode and the outer surface of the container in a completely intimate contact state. Therefore, in the case where a CVD film is formed in the container having the pressure reducing absorption face, it is particularly suitable to use the CVD film forming apparatus according to the present invention in which a gap may be provided between the inner wall face of the external electrode and the outer surface of the container.

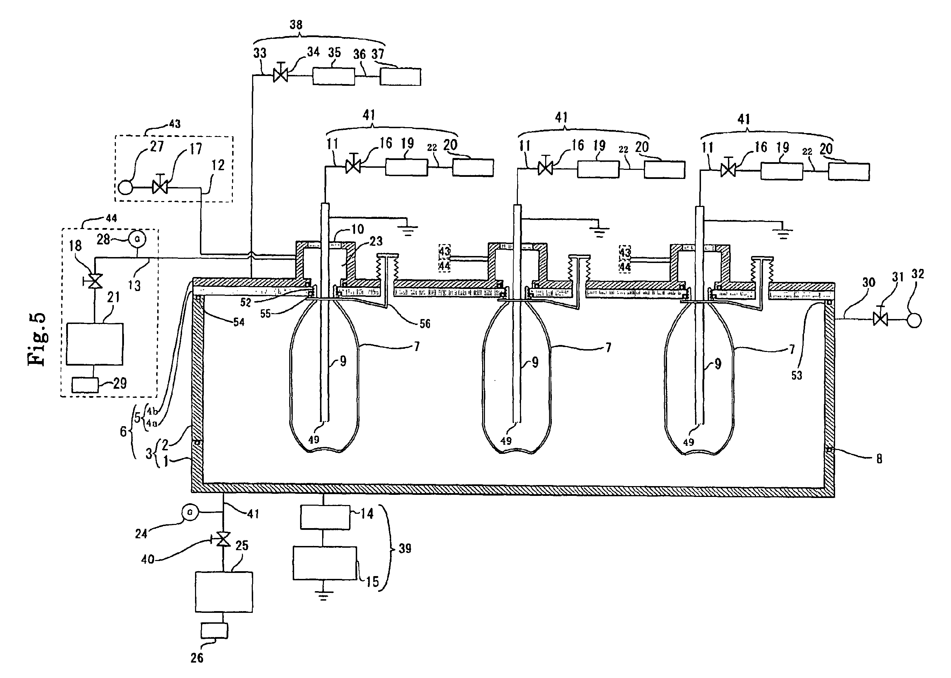

In the present invention, the number of plastic containers accommodated in a free space of the external electrode 3 is not limited to one. For example, as shown in FIG. 5, the size may be such that a plurality of plastic containers are accommodated. One connecting space is formed at the outside of the container which is a sealed space, irrespective of the number of containers.

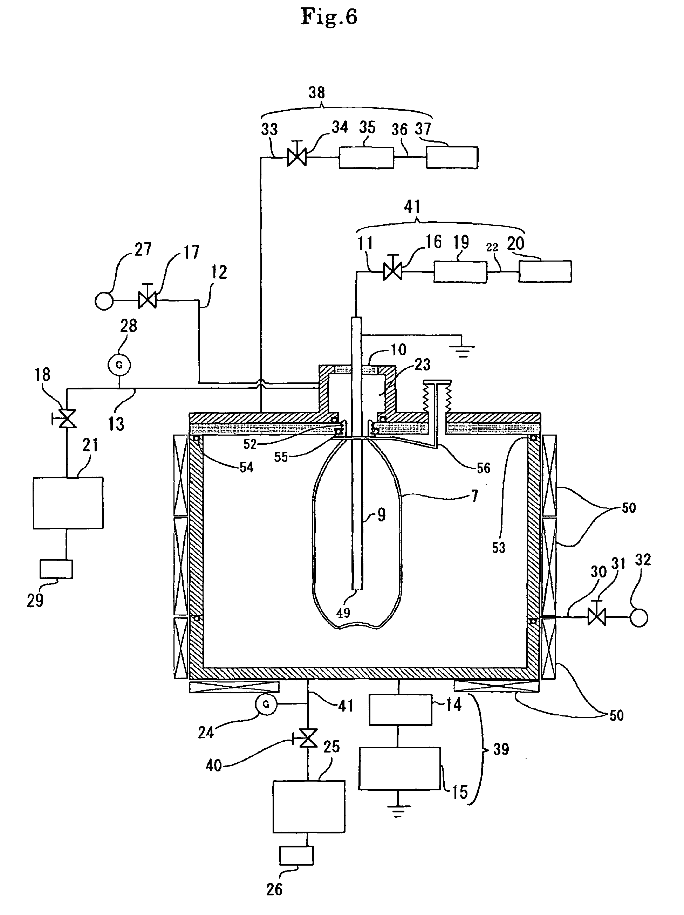

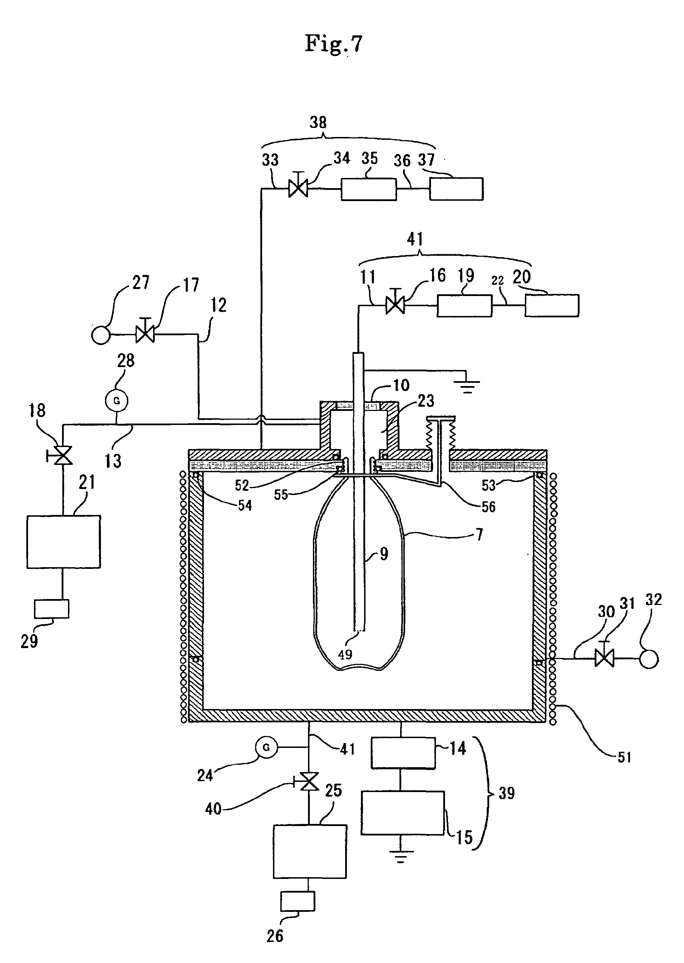

Moreover, in the present invention, as shown in FIG. 6, a permanent magnet 50 may be peripherally provided on the outer wall face of the external electrode 3. Alternatively, as shown in FIG. 7, an inductive coil 51 (current supply means of the inductive coil is not shown) may be periphery provided on the outer wall face of the external electrode 3. It is preferable that the plasma density at the outside of the container is increased by peripherally providing magnetic field generating means such as the inductive coil and permanent magnet shown in FIG. 6 or FIG. 7. The plasma density is improved by peripherally providing the magnetic field generating means, thereby ensuring plasma fire ignition at the outside of the container. Further, the container external gas can be stabilized as an electrical conducting body.

In addition, a trigger (not shown) is installed in the external electrode 3, whereby plasma fire ignition may be forcibly carried out.

The accommodating space in the external electrode portion 3 is sealed from the outside by means of an O-ring 8 disposed between an upper external electrode 2 and a lower external electrode 1. A reason why the external electrode 3 is divided into the upper external electrode 2 and the lower external electrode 1 is that the container 7 is easily mounted and removed. That is, the lower external electrode 1 is removed from the upper external electrode 2, and the container 7 is mounted and removed from the lower side of the upper external electrode 2. Each electrode ensures sealing properties by sandwiching the O-ring 8 or the like, for example.

The external electrode 3 may be divided into three or more sections. In addition, the external electrode 3 may not be divided. In the case where the electrode is not divided, it is possible to mount/remove the container 7 on/from an opening 53 of the external electrode 3.

The opening 53 is provided in order to introduce a source gas into the plastic container 7 or in order to install the cover 5 which serves to support the internal electrode 9 and the like. Therefore, when the plastic container 7 is accommodated in the free space of the external electrode 3, it is preferable that the opening 53 is provided such that the cover is positioned in the vicinity of a mouth part of the container. By providing the opening 53, the external electrode 3 is formed in a hollow shape with a bottom. The external electrode 3 may be formed such that it can be dissembled and assembled as required, and it is sufficient that the hollow shape with a bottom be established in that state during assembling. The cover 5 is set at the opening 53, thereby sealing the film forming chamber 6. At this time, the cover 5 and external electrode 3 ensure sealing properties by sandwiching, for example, the O-ring 54 or the like therebetween. In order to ensure insulation properties of the cover 5 and external electrode, they may be electrically insulated with a fluorine resin sheet, polyimide film, or PEEK (polyetheretherketone resin) film.

The cover 5 covers the opening 53 and seals the free space of the external electrode 3. Also, the mouth part opening 52 with which the mouth part of the plastic container 7 abuts is provided at the cover 5. An O-ring 55 is provided at a portion with which the mouth part opening 52 and the mouth part of the plastic container 7 come into contact. When the plastic container 7 has been accommodated, an intimate contact state is established such that a container internal gas and a container external gas of the plastic container 7 are not mixed with each other at the mouth part of the plastic container 7. Further, the plastic container 7 abuts with the mouth part opening 52 via an insulating body such that an electron is not grounded, the electron generating a self bias voltage on the surface of the plastic container 7 during plasma discharge. In the present invention, in order to achieve an insulated state, for example, the cover 5 is composed of an electrically conducting member 4b and insulating members 4a and 10 so that the insulating member 4a and the plastic container come into contact with each other. Furthermore, the cover 5 supports the internal electrode 9 such that the internal electrode 9 passes through the mouth part opening 52. When the internal electrode 9 is supported, the cover 5 causes the internal electrode 9 and external electrode 3 to establish an insulated state from each other. In the present invention, in order to achieve the insulated state, for example, the insulating member 4a of the cover 5 comes into contact with the opening 53 of the external electrode 3, and an insulating member 10 of the cover 5 comes into contact with the internal electrode 9.

The mouth part opening 52 connecting to a accommodating space in the external electrode 3 is provided at the cover 5, and a space 23 is provided at the inside of the cover 5. From the upper part of the electrically conducting member 4b, through the space 23 inside of the electrically conducting member 4b and the mouth part opening 52 of the electrically conducting member 4b and insulating member 4a, the internal electrode 9 is inserted into the free space in the external electrode 3. A proximal end of the internal electrode 9 is disposed at the upper part of the electrically conducting member 4b. On the other hand, a distal end of the internal electrode 9 is provided at the free space in the external electrode 3, and is disposed at the inside of the plastic container 7 accommodated in the external electrode 3.

The insulating member 4a is disposed beneath the electrically conducting member 4b to form the cover 5, and the external electrode 3 is disposed beneath the insulating member 4a. This external electrode 3 includes the upper external electrode 2 and the lower external electrode 1. This external electrode is configured such that the upper part of the lower external electrode 1 can be removably mounted on the lower part of the upper external electrode 2 by way of the O-ring 8. The plastic container 7 can be mounted by removably mounting the upper external electrode 2 and the lower external electrode 1. In addition, the external electrode 3 is insulated from the cover 5 by means of the insulating member 4a.

A container support device 56 for supporting the plastic container 9 in an electrically insulating state and fixing the container is installed at the cover 5. The container support device 56 may be a floating potential. However, as in the apparatus shown in FIG. 2 or FIG. 3, in the case where the plastic container 7 is supported at the bottom part of the external electrode 3, it is possible to eliminate the container support device 56.

The internal electrode 9 has a tubular shape composed of a hollow at the inside thereof, and is removably disposed at the inside of the plastic container 7. At this time, it is preferable that the internal electrode 9 is in non-contact with the inner surface of the plastic container 7 in order to generate plasma discharge at the inside of the plastic container 7. As shown in FIG. 1, when the plastic container 7 is mounted on the film forming chamber 6, the internal electrode 9 is disposed in the external electrode 3 and is disposed at the inside of the plastic container 7. A gas blow port 49 is provided at a distal end of the internal electrode 9. Further, it is preferable that the internal electrode 9 is grounded. Here, it is preferable that the internal electrode 9 is formed of an electrically conducting tubular base to which a hard gold alloy coating of 2 microns to 10 microns in coated thickness is applied. It is preferable that the kind of a hard gold alloy plating be an acidic hard gold alloy plating such as 99.7Au-0.3Co, 99.8Au-0.2Ni and the like. At this time, it is preferable that the electrically conducting tubular base is formed of SUS304 which is surface polished. It is preferable polishing is polishing due to mechanical processing, and is formed on a mirror face of buff #600. Further, it is preferable that an inner bore of the internal electrode 9 is 1.5 mm or less in order to prevent plasma generation at the inside of the tube of the internal electrode, and more preferably 1.0 mm or less. By defining the inner bore to be 1.5 mm or less, an occurrence of electrode dirt at the inside of the tube of the internal electrode can be restricted. In addition, it is preferable that the thickness of the internal electrode is 1 mm or more in order to ensure a mechanical strength. By forming the internal electrode 9 as described above, the adhering of the electrode dirt can be prevented, and plasma discharge can be stabilized.

In the case of an apparatus for forming films on a plurality of plastic containers shown in FIG. 5 at the same time, a plurality of internal electrodes 9 are provided. That is, the plurality of internal electrodes 9 are supported at the cover 5. Container internal gas introducing means 41, air exhaust means 44, and leak means 43 are provided at each of the internal electrodes 9.

The containers according to the present invention are containers which use a cover or a stopper or a seal, and include containers used in an open state which do not use these. The size of the opening is determined according to the contents. The plastic containers include plastic containers having a prescribed thickness which have moderate rigidity, and plastic containers formed from a sheet material having no rigidity. The substances filled into the plastic containers according to the present invention can be beverages such as carbonated beverages or fruit juice beverages or soft drinks or the like, as well as medicines, agrichemicals, or dried foods which hate moisture absorption or the like.

As for the resin used for molding the plastic container of the present invention, polyethylene terephthalate resin (PET), polyethylene terephthalate type copolyester resin (a copolymer called PETG which uses cyclohexane demethanol in place of ethylene glycol in the alcohol component of polyester, generated by Eastman Chemical Company), polybutylene terephthalate resin, polyethylene naphthalate resin, polyethylene resin, polypropylene resin (PP), cycloolefin copolymer resin (COC, ring olefin copolymer), ionomer resin, poly-4-methylpentene-1 resin, polymethyl methacrylate resin, polystyrene resin, ethylene-vinyl alcohol copolymer resin, acrylonitrile resin, polyvinyl chloride resin, polyvinylidene chloride resin, polyamide resin, polyamide imide resin, polyacetal resin, polycarbonate resin, polysulfone resin, or ethylene tetrafluoride resin, acrylonitrile-styrene resin, acrylonitrile-butadiene-styrene resin can be cited. Among them, PET is particularly preferred.

The container internal gas introducing means 41 introduces the container internal gas supplied from container internal gas generating source 20 into the plastic container 7. That is, one side of a pipeline 11 is connected to a proximal end of the internal electrode 9, and the other side of this pipeline 11 is connected to one side of a mass flow controller 19 via a vacuum valve 16. The other side of the mass flow controller 19 is connected to the container internal gas generating source 20 via the pipeline. This container internal gas generating source 20 generates the source gas or discharge gas for plasma generation.

A source gas is selected as the container internal gas in case of forming a CVD film on the inner surface of the plastic container. Aliphatic hydrocarbons, aromatic hydrocarbons, hydrocarbons containing oxygen, hydrocarbons containing nitrogen and the like which are a gas or a liquid at normal temperature are used as the source gas. In particular, benzene, toluene, 0-xylene, m-xylene, p-xylene, cyclohexane and the like which have a carbon number of 6 or higher are preferred. In the case of use in a container of food and the like, from the viewpoint of hygiene, aliphatic hydrocarbons, namely, ethylene hydrocarbons such as ethylene, propylene or butylene or the like, or acetylene hydrocarbons such as acetylene, allyrene or 1-butyne or the like are preferred. These source materials may be used individually, or a mixed gas of two or more kinds may be used. Further, these gases may be used in a form where they are diluted by a noble gas such as argon or helium. Further, in case of forming a silicon-containing DLC film, a Si-containing hydrocarbon based gas is used.

A DLC film herein is a film called an i-carbon film or an amorphous carbon hydride film (a-C : H), and also includes a hard carbon film. Further, a DLC film is an amorphous-state carbon film, and includes SP³ bonding. A hydrocarbon based gas, for example, an acetylene gas is used as the source gas for forming this DLC film, and a Si-containing hydrocarbon based gas is used as the source gas for forming the Si-containing DLC film. Such a DLC film is formed on the inner surface of the plastic container, and thereby obtaining a container which can be used disposably, or returnably as a container for carbonated beverage, sparkling beverage and the like.

On the other hand, a discharge gas is selected as a container internal gas in the case where the inner surface of the plastic container 7 is subjected to plasma surface modifying. Like a source gas, a gas generated as a plasma is selected. It is preferable that the discharge gas is a gas generated as a plasma including a rare gas such as helium or argon, nitrogen, oxygen, carbon dioxide, fluorine, a vapor deposition gas, an ammonia gas, tetrafluoride gas, or a mixture gas thereof.

Container external gas introducing means 38 is an outside of the plastic container 7, and introduces a source gas or a discharge gas to be generated as a plasma in a sealed space (hereinafter, referred to as a "container outside") in the film forming chamber 6. The container external gas introducing means 38 introduces a container external gas supplied from the container external gas generating source 37. That is, of the film forming chamber 6, a container external gas introducing port (not shown) is provided at a predetermined portion of the cover 5 capable of introducing a gas into the container outside or the external electrode 3. FIG. 1 shows a case in which a container external gas introducing port has been provided at the cover 5. When the container external gas introducing port provided at the cover 5 or external electrode 3 is defined as a start point, one side of a pipeline 33 is connected, and the other side of this pipeline 33 is connected to one side of a mass flow controller 35 via a vacuum valve 34. The other side of the mass flow controller 35 is connected to the container external gas generating source 37 via a pipeline 36. This container external gas generating source 37 is provided to generate a source gas or a discharge gas to be generated as a plasma.

The container external gas is provided as a source gas or a discharge gas generated as a plasma. Thus, a plasma is generated at the container outside which is a sealed space, by using a high frequency supplied to the external electrode 3. The container external gas generated as a plasma is provided as an electrically conducting body, and thus, a high frequency is electrically introduced into the outer surface of the plastic container 7. By using a high frequency electrically introduced into the outer surface of the plastic container 7, a container internal gas is generated as a plasma at the inside of the plastic container 7.

The container internal gas and the container external gas are designed so as not to be mixed with each other, and thus, plasmas are ignited as fires independently at the container inside and at the container outside which is a sealed space, respectively.

The source gas is selected as a container external gas in the case where a CVD film is formed on the outer surface of the plastic container. As a source gas, a gas of the same type as that in the case of the source gas of the container inside gas is selected.

On the other hand, a discharge gas is selected as a container external gas in the case where the outer surface of the plastic container 7 is subjected to plasma surface modifying. Like a source gas, a gas to be generated as a plasma is selected. As a discharge gas, a gas of the same type as that in the case of the discharge gas of the container external gas is selected.

The space 23 in the electrically conducting member 4b is connected to one side of a pipeline 13, and the other side of the pipeline 13 is connected to a vacuum pump 21 via the vacuum valve 18. This vacuum pump 21 is connected to an exhaust duct 29.

The space 23 in the electrically conducting member 4b is connected to one side of a pipeline 12, and the other side of the pipeline 12 is connected to a leak source 27 for atmospherically releasing the container inside via a vacuum valve 17.

In order to atmospherically release a sealed space of the container outside, the external electrode 3 is connected to one side of a pipeline 30, and the other side of the pipeline 30 is connected to a leak source 32 via a vacuum valve 31.

The space in the film forming chamber 6 is connected to one side of a pipeline 41, and the other side of the pipeline 41 is connected to a vacuum pump 25 via a vacuum valve 40. This vacuum pump 25 is connected to an exhaust duct 26.

The high frequency supply means 39 comprises: an automatic matching device (matching box) 14 connected to the external electrode 3; and a high frequency power source 15 connected to the automatic matching device 14 via a coaxial cable. The high frequency power source 15 is grounded.

The high frequency power source 15 is provided to generate a high frequency wave which is an energy for generating a container external gas and a container internal gas as a plasma. It is preferable that this power source is provided as a transistor type high frequency power source and a high frequency power source for carrying out matching in a variable frequency manner or in an electronic manner in order to reduce a time required for plasma fire ignition. The frequency of the high frequency power source is in the range from 100 kHz to 1000 MHz. For example, an industrial frequency of 13.56 MHz is used. A high frequency output is selected as 10 W to 2000 W, for example.

The automatic matching device 14 is provided to make adjustment so as to coincide with an impedance of the internal electrode 9 and film forming chamber 6, an inductance L, and a capacitance C.

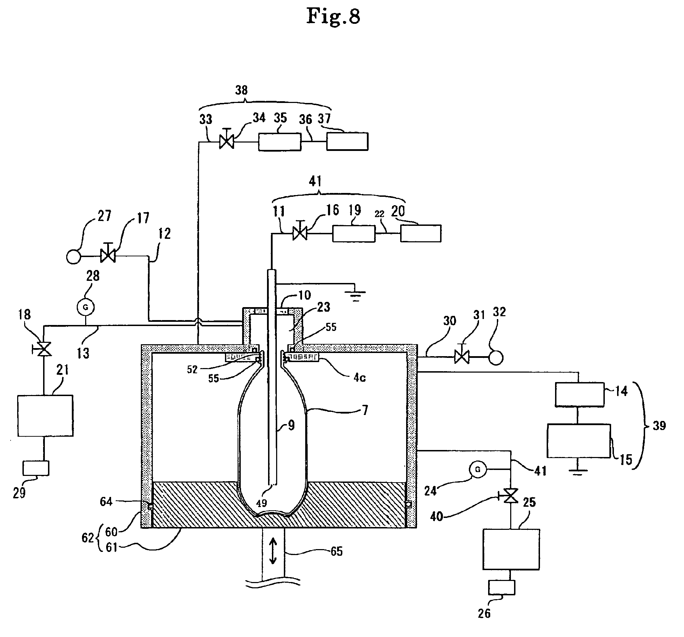

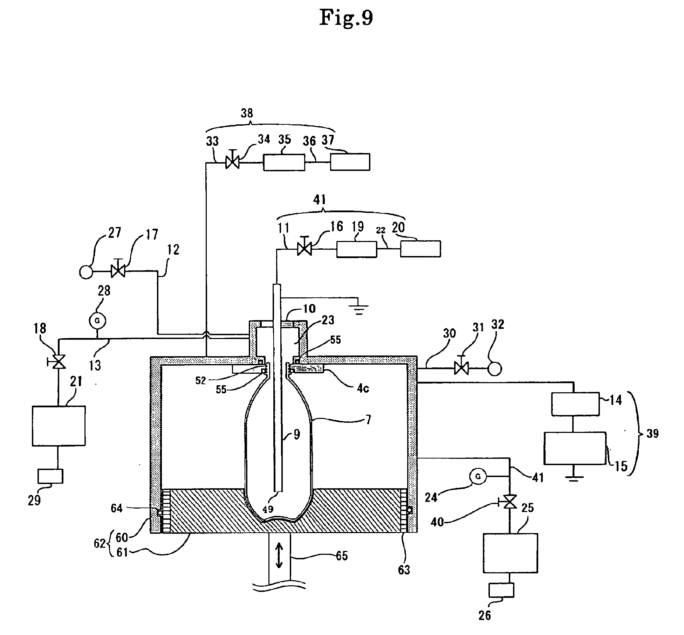

The manufacturing apparatus according to the present embodiment may be provided as an apparatus according to another embodiment shown in FIG. 8 to FIG. 11. In the apparatus of FIG. 8, an external electrode 62 including an upper external electrode 60 and a lower external electrode 61 is exemplified as a film forming chamber. In this case, no cover is provided unlike the foregoing embodiment. The lower external electrode 61 is supported by elevating means 65, and the external electrode 62 (film forming chamber) can be freely opened and closed by elevation of the lower external electrode 61. Similar elevating means 65 is provided in the apparatus of FIG. 9 to FIG. 11 as well.

In the apparatus shown in FIG. 9, the lower external electrode 61 is insulated from the upper external electrode 60 connected to the high frequency supply means 39 by means of an insulating member 63 such as a heat resistance plastic resin. In this manner, a self bias voltage applied to the bottom part and body part of the plastic container is lowered as compared with a case of the apparatus of FIG. 8 in which no insulation is provided. Therefore, in the case where the film thickness of the bottom part is large, the film thickness of the CVD film can be uniformed by the apparatus of FIG. 9 in which, for example, the insulating member 63 has been provided.

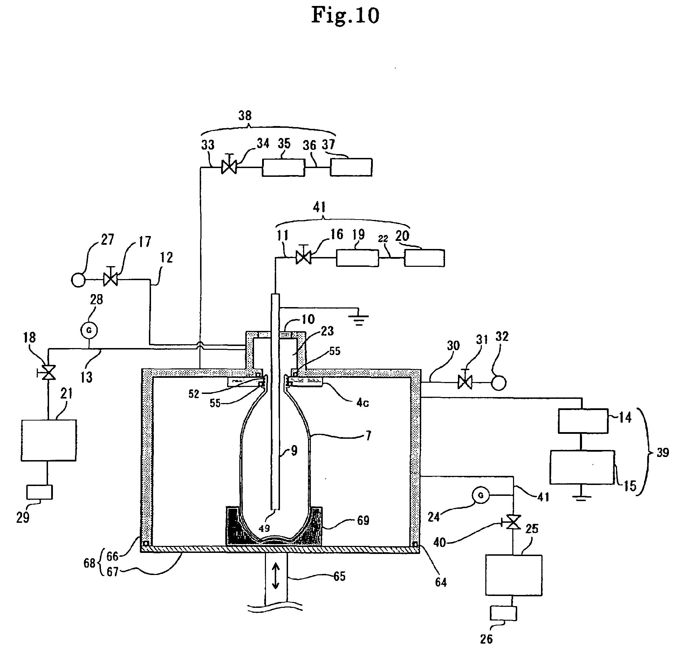

Further, the apparatus shown in FIG. 10 is provided as another aspect of the apparatus shown in FIG. 8, and a sufficient self bias voltage can be applied to the bottom part and body part of the container by using a container support base 69 composed of an electrically conducting body. An external electrode 68 functions as a film forming chamber.

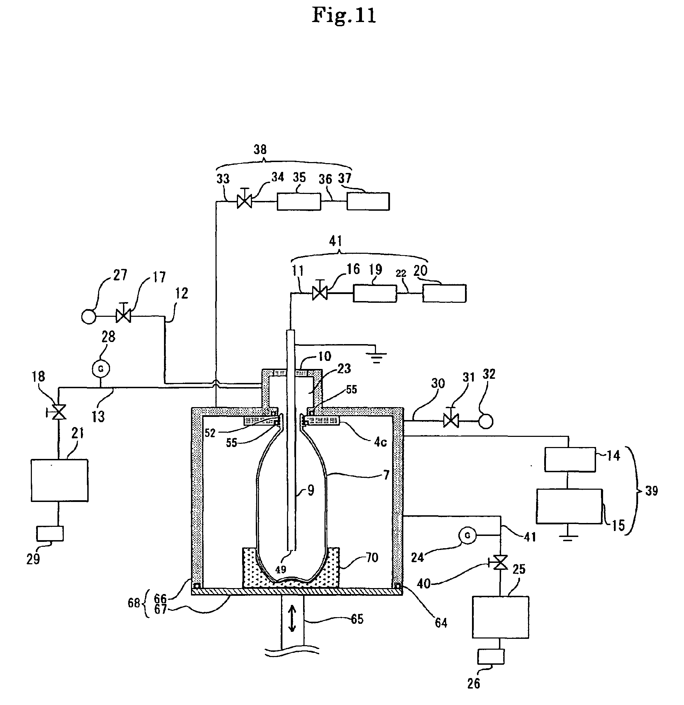

The apparatus shown in FIG. 11 is provided as another aspect of the apparatus shown in FIG. 9, and a self bias voltage can be adjusted by using a container support base 70 composed of an insulating member such as a heat-resistant plastic resin instead of providing the insulating member 63. A film thickness of the bottom part can be adjusted in the same manner as in the case of FIG. 9. The external electrode 68 functions as a film forming chamber.

With the container support bases 69 and 70, it becomes possible to hold a plastic container in a stable manner during elevation of the lower external electrode 67. When the container is set at the film forming chamber, the container mouth part can be easily sealed. Either of the container support bases 69 and 70 may be or may not be fixed to the lower external electrode 67.

The capacitance of the film forming chamber can be increased or decreased as required if the plastic container can be accommodated. FIG. 11 shows a case in which the capacitance of the film forming chamber is decreased, as compared with that of FIG. 10.

Now, a description will be given with respect to a method for forming a CVD film, in particular, a DLC film, by using the CVD film forming apparatus of the present invention.

A description will be given with respect to a container mounting process for mounting a plastic container in the film forming chamber 6. The container outside in the film forming chamber 6 is atmospherically released by opening the vacuum valve 31. The inside of the plastic container 7 is atmospherically released by opening the vacuum valve 17. In addition, the lower external electrode 1 of the external electrode portion 3 is established in a state in which the electrode 1 is removed from the upper external electrode 2. A coating free plastic container 7 is installed to be inserted into a space in the upper external electrode 2 from the lower side of the upper external electrode 2. At this time, the internal electrode 9 is established in a state in which the electrode is inserted into the plastic container 7. Next, the lower external electrode 1 is mounted at the lower part of the upper external electrode 2, and the external electrode 3 is sealed by means of the O-ring 8.

The cover 5 and external electrode 3 are removed, and the plastic container 7 is installed on the external electrode 3 having a hollow shape with bottom. Then, the cover 5 is lowered so as to seal the opening 53 of the external electrode 3, whereby the container may be mounted.

Next, a description will be given with respect to a film pre-forming gas adjustment process for replacing the inside of the plastic container 7 with the container internal gas, and making adjustment to a predetermined pressure; and replacing the container outside with the container external gas and making adjustment to a predetermined pressure. After the vacuum valve 17 has been closed, the vacuum valve 18 is opened, and the vacuum pump 21 is actuated. In this manner, the inside of the plastic container 7 is exhausted through the pipeline 13, and a vacuum state is established. At this time, the inner pressure of the plastic container 7 ranges from 2.6 Pa to 66 Pa (2 × 10⁻² Torr to 5 × 10⁻¹ Torr). After the vacuum valve 31 has been closed at the same time as this work, the vacuum valve 40 is opened, and the vacuum pump 25 is actuated. In this manner, the inside of the container outside which is a sealed space is exhausted through the pipeline 41, and a vacuum state is established. At this time, the inner pressure of the container outside ranges from 2.6 Pa to 66 Pa (2 × 10⁻² Torr to 5 × 10⁻¹ Torr).

Next, the vacuum valve 16 is opened, the container internal gas is generated in the container internal gas generating source 20, and this container internal gas is introduced into the pipeline 22. The container internal gas whose flow rate is controlled by means of the mass flow controller 19 is blown from the gas blow port 49 through the pipeline 11 and the internal electrode 9 of a grounding electrical potential. In this manner, the container internal gas is introduced into the plastic container 7. In addition, the inside of the plastic container 7 is stabilized so that the container internal gas is maintained at a pressure (for example, about 6.6 Pa to 665 Pa (about 0.05 Torr to 5.0 Torr) suitable to the container internal gas being generated as a plasma, due to a balance between the controlled gas flow rate and an air exhaust capability. At the same as this work, the vacuum valve 34 is opened, and the container external gas is generated at the container external gas generating source 37. This container external gas is introduced into the pipeline 36, and the container external gas whose flow rate is controlled by means of the mass flow controller 35 is blown in the container outside which is a sealed space from a container external gas introducing port (not shown) through the pipeline 33. In this manner, the container external gas is introduced into the container outside. Then, the inside of the container outside is stabilized so that the container external gas is maintained at a pressure (for example, about 6.6 Pa to 665 Pa (about 0.05 Torr to 5.0 Torr)) suitable to the container external gas being generated as a plasma, due to a balance between the controlled gas flow rate and an air exhaust capability.

Now, a description will be given with respect to a CVD film forming process for supplying a high frequency output to the external electrode 3, and then, generating a container internal gas and a container external gas as plasmas substantially at the same time, thereby forming a DLC film on at least one of the inner surface and outer surface of a plastic container. An RF output (for example, 13.56 MHz) is supplied to the external electrode 3 by the high frequency supply means 39. In this manner, a plasma is ignited as a fire between the external electrode 3 and the internal electrode 9. At this time, the inside of the plastic container 7 and the outside of the container form another space while a wall face of the plastic container is defined as a boundary. Plasmas are ignited as fires at both of these portions. That is, a plasma is generated at the container outside due to a high frequency supplied to the external electrode 3. The container external gas generated as a plasma is defined as an electrically conducting body, a high frequency is guided to the outer surface of the plastic container 7, and the container internal gas is generated as a plasma at the inside of the plastic container 7 as well.

At this time, the automatic matching device 14 matches an impedance by an inductance L and a capacitance C such that the reflection wave from the whole electrode supplied to be outputted is minimal.

In this manner, a hydrocarbon based plasma is generated in a space filled with a source gas, and a DLC film is formed on at least one of the inner surface and outer surface of the plastic container 7. At this time, the film forming time is as short as about several seconds. Next, the RF output from the high frequency supply means 39 is stopped, the plasma is eliminated, and the forming of the DLC film is terminated. Substantially at the same time, the vacuum valve 16 and the vacuum valve 34 are closed, and supply of the container internal gas and container external gas is stopped.

Now, a description will be given with respect to a film post-forming gas adjustment process for restoring pressures of the inside and outside of a coated container to an atmospheric pressure. In order to remove the container internal gas or container external gas which remains in the plastic container 7 and in the container outside, the vacuum valves 18 and 41 are opened, and these gases are exhausted by means of the vacuum pumps 21 and 25. Then, the vacuum valves 18 and 40 are closed, and air exhaust is terminated. At this time, the pressures in the inside of the plastic container 7 and in the outside of the container are set to 6.6 Pa to 665 Pa (0.05 Torr to 5.0 Torr), respectively. Then, the vacuum valves 17 and 31 are opened. In this manner, air enters a space in the cover 5 and the inside of the plastic container 7. Further, the air enters the inside of the container outside, and the inside of the film forming chamber 6 is atmospherically released.

In the case where the apparatus of FIG. 5 has been used, an operation similar to the foregoing is carried out in each plastic container, thereby making it possible to form films on a plurality of plastic containers at the same time.

Next, a description will be given with respect to a container removing process for removing a coated container. The lower external electrode 1 of the external electrode 3 is established in a state in which the electrode 1 has been removed from the upper external electrode 2. The plastic container 7 accommodated in a space in the upper external electrode 2 is removed from the lower side of the upper external electrode 2. The cover 5 and external electrode 3 are removed, whereby the plastic container 7 mounted on the external electrode 3 having a hollow shape with bottom may be removed.

Now, a description will be given with respect to a specific embodiment in the case where a source gas or a discharge gas has been selected as a container external gas or a container internal gas. In the present invention, there are three combinations of selections of the container external gas and container internal gas. These combinations are shown in Table 1.

**(Table 1)**

| | | | | |
|---|---|---|---|---|
| | a container external gas | a container internal gas | Outer surface of a container after CVD film forming | Inner surface of a container after CVD film forming |
| gas combination 1 | a discharge gas | a source gas | plasma surface modifying | CVD film forming |
| gas combination 2 | a source gas | a discharge gas | CVD film forming | plasma surface modifying |
| gas combination 3 | a source gas | a source gas | CVD film forming | CVD film forming |

In gas combination 1, a CVD film is formed on a container inner surface, and on the other hand, an outer surface can be subjected to plasma surface modifying. In particular, when, for example, an acetylene gas is used as a source gas which has been exemplified previously, a fine DLC film having gas barrier properties can be formed on the inner surface of the plastic container. A DLC film is formed on the container inner surface, thereby making it possible to provide gas barrier properties and vapor deposition barrier properties such as oxygen or carbon dioxide, and further to restrict adsorption on the container wall face such as an aroma component and adsorption to a container resin. On the other hand, plasma surface modifying on the container outer surface is as follows. That is, by using a rare gas such as helium or argon which is an inert gas as a discharge gas of the container external gas, surface roughness of the plastic container outer surface due to inert plasma processing is promoted, thus making it possible to ensure the improvement of adhesive properties such as a label, the improvement of applicability to ink printing, and prevention of static electricity (prevention of adhering of dirt). By using hydrogen, oxygen, nitrogen, steam, ammonia gas, tetra-fluoride carbon, or a mixture gas thereof as a discharge gas, a functional group caused by reactive plasma processing can be provided, and adhesive properties such as a label can be improved. Therefore, different functions can be provided independently on the container inner surface and the container outer surface.

In gas combination 2, a CVD film is formed on a container outer surface, and on the other hand, an inner surface can be subjected to plasma surface modifying. When, for example, an acetylene gas is used as a source gas which has been exemplified previously, a DLC film can be formed on the container outer surface. It becomes possible to ensure gas barrier properties by the DLC film formed on the container outer surface. Further, it becomes possible to achieve lowering of a static frictional coefficient and to prevent a scratch on an outer face. On the other hand, plasma surface modifying on a container internal surface is as follows. That is, when helium, argon, oxygen, nitrogen or the like is used as a discharge gas of the container internal gas, sterilization of microorganisms can be achieved. This sterilization action is greatly due to ultraviolet active species as well as only plasma active species. By using nitrogen, oxygen, carbon dioxide, or a fluorine, or alternatively, a mixture gas thereof as a discharge gas, polarity due to reactive plasma processing is introduced, whereby the wetting properties of the container inner surface can be improved.

In gas combination 3, CVD films can be formed on both of the container internal surface and the container outer surface. When, for example, an acetylene gas is used as a source gas which has been exemplified previously, a fine DLC film having gas barrier properties can be formed on the container inner surface and outer surface. The DLC film with the gas barrier properties is formed on both wall faces of the plastic container, whereby the plastic container with a ultra-high gas barrier properties can be manufactured. In addition, it becomes possible to reduce the DLC film thickness in order to ensure the gas barrier properties on both wall faces, and a film forming time can be reduced. Further, the DLC film is formed on the container outer surface, thereby making it possible to lower a static frictional coefficient and to prevent a scratch on an outer face.

In the embodiment, PET bottles for beverages are used as containers in which a thin film is formed inside, but it is also possible to use containers used for other uses.

Further, in the embodiment, a DLC film or a DLC film containing Si is cited as a thin film to be formed by the CVD film forming apparatus of the present invention, but it is also possible to use the above-described film forming apparatus at the time when other thin films are formed inside containers.

The film thickness of the DLC film is formed so as to be in the range from 0.003 microns to 5 microns.

### Examples

Examples are shown with respect to a case in which a DLC film is formed on a plastic container in accordance with the above-described film forming method by using an apparatus equivalent to that shown in FIG. 1.

### (1) Container

A PET bottle was used as a plastic container. The height of the PET bottle was 207 mm, the thickness was 0.3 mm, the capacitance of the container was 500 ml, and the inner surface area was 400 cm². The shape of the bottle was defined as a container (carbonation round type) of FIG. 4(a), and the diameter of the body part was 68.5 mm. When the plastic container was accommodated in an external electrode, a gap between an outer surface of the container and an inner wall face of the external electrode was 1.0 mm. In addition, an interval between an outer surface of a neck part of the container and an inner wall face of the external electrode was 20 mm. Further, a bottle (heat resistance round type) of FIG. 4(e) and a PET bottle of a container (heat resistance rectangle type) of FIG. 4(f) were used. The PET bottle of the container (heat resistance round type) of FIG. 4(e) and that of the container (heat resistance rectangle type) of FIG. 4(f) each have a pressure reducing absorption face or a panel. A carbonation container was formed in a conical shape because an inner pressure of a carbonated gas is present. The heat resistance container has partial recess and protrusion portions at its body part. In the case where the content processed at a temperature of about 80°C to 95°C is charged and sealed in a state in which that temperature is maintained, and is shipped as a product, if the content is cooled up to a normal temperature, it is inevitable that the inside of the container is pressure-reduced, and a change in shape of the container itself occurs. A wall face such as the body part having its recess and protrusion parts denotes a pressure reducing absorption face or a panel. The characteristics of each of the containers of FIG. 4(a), FIG. 4(e), and FIG. 4(f) were summarized in Table 2.

**(Table 2)**

| | carbonation round type | heat resistance round type | heat resistance rectangle type |
|---|---|---|---|
| capacitance ml | 500 | 500 | 500 |
| thickness mm | 0.3 | 0.35 | 0.35 |
| inner surface area cm² | 400 | 400 | 390 |
| height mm | 207 | 209 | 207 |
| maximum diameter of the body part mm | 68.5 | 69 | - |
| □ length(length on a side) mm | - | - | 60 |
| gap(maximum diameter - a panel portion) mm | - | 4.5 | - |
| gap(maximum length - a panel portion) m | - | - | 2.0 |
| gap (maximum length - waist portion)mm | - | - | 4.0 |
| a gap between an outer surface of the container and an inner wall face of the external electrode mm | 1.0 | 5.0∼5.5 | 2.5∼5.0 |
| a an interval between an outer surface of a neck part of the container and an inner wall face of the external electrode mm | 20 | 20 | 18∼20 |

### (2) Film forming condition

The film forming conditions of Examples 1 to 8 were summarized in Table 3. A high frequency power source was used as having an industrial frequency of 13.56 MHz. In Comparative example 1, an unprocessed PET container was used. Table 3 shows evaluation results of degree of oxygen permeation and wetting properties of printing applicability together. With respect to the external part, a gap at a neck part is 20 mm, and there is no problem because a plasma can occur. However, a gap at a body part is too small (1 mm), and a plasma is unlikely to occur. At a portion with its small gap as well, an external pressure was highly set in order to ensure that a plasma is likely to occur. In addition, argon of 2% was added to source gases such as a nitrogen gas and an acetylene gas, whereby a plasma was likely to occur.

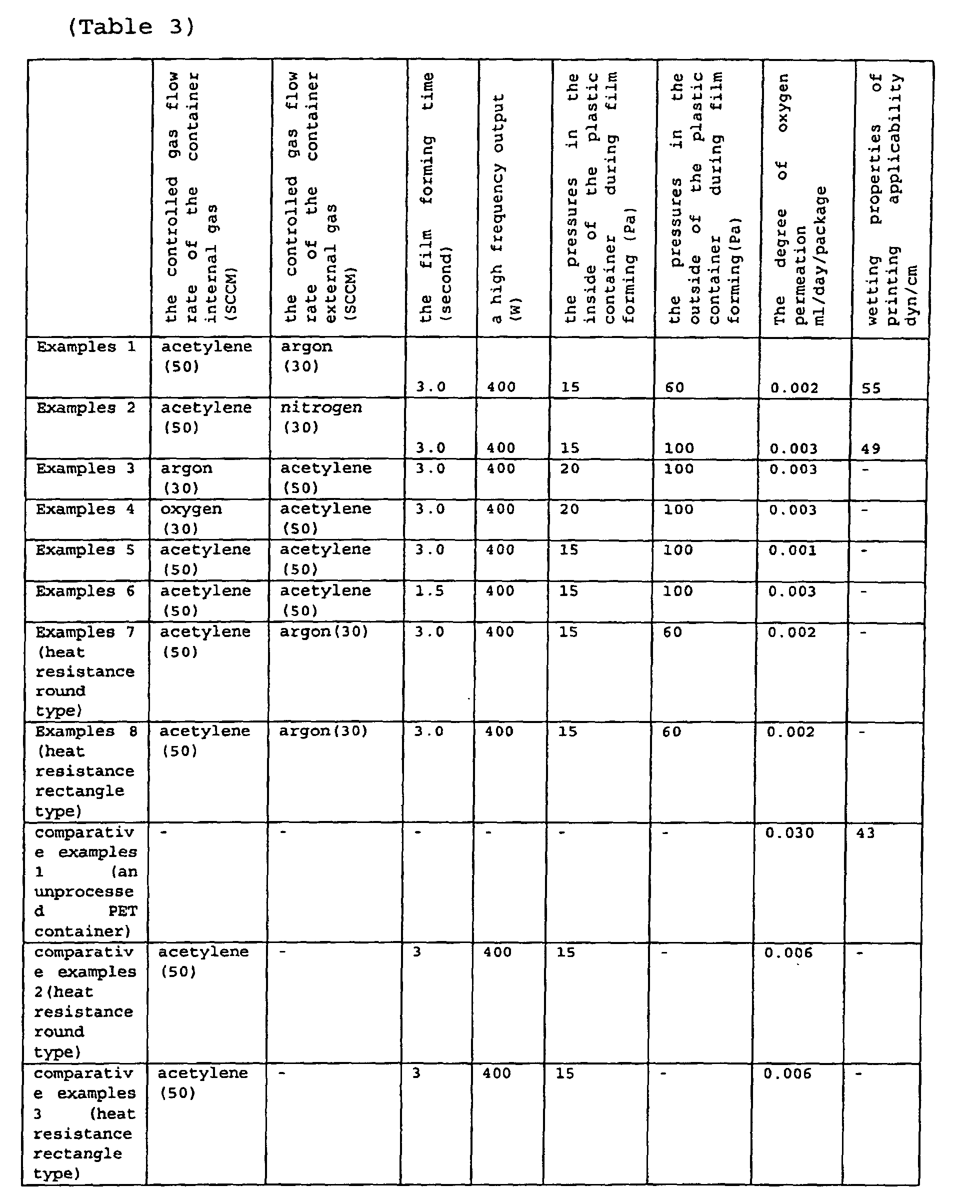

In the container of Example 1, a DLC film of 150 angstroms in film thickness was formed on an inner surface of the PET bottle. In addition, an outer surface of the container was surface roughened, and printing applicability was improved as compared with that of Comparative example 1. The degree of oxygen permeation of Example 1 was 0.002 ml for each container a day. The degree of oxygen permeation of Comparative example 1 was 0.030 ml for each container a day. That is, the oxygen gas barrier properties were improved by 15 times.

Evaluation of printing applicability was by measurement of a surface tensile strength of the container based on a Zisman's critical surface tensile strength approach. A measurement site was a flat portion of the body part. An unprocessed PET was 43 dyn/cm, and a PET of 45 dyn/cm or more was improved in printing applicability. The degree of oxygen permeation was measured under a condition of 22°C × 60%RH by using Oxtran available from Modern Control Co., Ltd. In the present invention, the PET container shown in Table 2 was used, and the inner surface area of this container was 400 cm² for each container or 390 cm² for each container. The degree of oxygen permeation was calculated for each container. In the case where this degree is converted per area (m²), such conversion may be carried out in consideration of the inner surface area of the container. Such an area is not taken into consideration because there is no gas permeation from a bottom cover. However, the present invention is not limited by the capacity and shape of the container of this Example.

In the container of Example 2, a DLC film of 150 angstroms in film thickness was formed on an inner surface of a PET bottle. In addition, with respect to the outer surface of the container, due to an ion bombardment effect using an inert gas, printing applicability was improved as compared with that of Comparative example 1. The degree of oxygen permeation of Example 2 was 0.003 ml for each container a day. The oxygen gas barrier properties were improved by 10 times as compared with that of Comparative example 1.

In the container of Example 3, a DLC film of 120 angstroms in film thickness was formed on an outer surface of a PET bottle. The degree of oxygen permeation of Example 3 was 0.003 ml for each container a day. The oxygen gas barrier properties were improved by 10 times as compared with that of Comparative example 1.

In the container of Example 4, a DLC film of 110 angstroms in film thickness was formed on an outer surface of a PET bottle. In addition, the wetting properties of the inner surface of the container were improved as compared with that of Comparative example 1. In actuality, when a carbonated drink is put into the container, an amount of bubbles of carbonated gas was decreased at a visual level. The degree of oxygen permeation of Example 4 was 0.003 ml for each container a day. The oxygen gas barrier properties were improved by 10 times as compared with that of Comparative example 1.

In the container of Example 5, a DLC film of 120 angstroms in film thickness was formed on an outer surface of a PET bottle, and a DLC film of 150 angstroms in film thickness was formed in an inner surface. The degree of oxygen permeation of Example 5 was 0.001 ml for each container a day. The oxygen gas barrier properties were improved by 30 times as compared with that of Comparative example 1.

In the container of Example 6, a DLC film of 60 angstroms in film thickness was formed on an outer surface of a PET bottle, and a DLC film of 80 angstroms in film thickness was formed in an inner surface. The degree of oxygen permeation of Example 6 was 0.003 ml for each container a day. The oxygen gas barrier properties were improved by 10 times as compared with that of Comparative example 1.

The containers of Examples 7 and 8 were provided as heat resistance round type containers each having a pressure reducing absorption face on an outer wall face of the container. When the pressure reducing absorption face exists, a gas between the outer wall face of the container and the inner wall face of the external electrode changes according to irregularities on the pressure reducing absorption face and the gap increases at a recess portion. However, in Examples 7 and 8, although a change in such irregularities and an increase in gap at the recess portion occurred, a similar fine DLC film was formed at any portion.

In Examples 1 to 8, fine DLC films having gas barrier properties was successfully formed. At a neck portion of the container, although a gap between the outer wall face of the container and an external electrode face is as large as about 20 mm, a similar fine DLC film at another site was formed.

On the other hand, in Comparative examples 2 and 3, film forming was carried out in a state in which there does not externally exist an external gas of the container generated as a plasma, the external gas serving as an electrically conducting body. In Comparative example 2, although a gap between a protrusion portion of a pressure reducing absorption face and an inner wall face of an external electrode was 1 mm, a gap between a recess portion of the pressure reducing absorption face and the inner wall face of the external electrode was in the range of 5.0 mm to 5.5 mm, and a uniform DLC film was not successfully formed. In addition, at the neck part of the container, because a gap of 20 mm exists, a DLC film at this portion was not formed as a fine DLC film. Further, in Comparative example 3, although a gap between a protrusion portion of a pressure reducing absorption face and an inner wall face of an external electrode was 1 mm, a gap between a recess portion of the pressure reducing absorption face and the inner wall face of the external electrode was in the range of 2.5 mm to 5.0 mm, and a uniform DLC film was not successfully formed. In addition, at the neck part of the container, because a gap of 18 mm to 20 mm exists, a DLC film at this portion was not formed as a fine DLC film.

Examples 1 to 8 were carried out by using a CVD film forming apparatus equivalent to that of FIG. 1. However, in the CVD film forming apparatus of FIG. 2 and FIG. 3 as well, a result similar to that in the case of Examples 1 and 2 was obtained. In addition, in the CVD film forming apparatus of FIG. 5 as well, a result similar to those of Examples 1 to 8 was obtained in each container.

## Claims

1. A plasma CVD film forming apparatus, **characterized by** comprising:
an external electrode being compatible with a vacuum chamber having a free space for accommodating a plastic container, the vacuum chamber being capable of accommodating the plastic container in the free space such that a container internal gas and a container external gas of the plastic container are not mixed with each other;
an internal electrode removably disposed at the inside of the plastic container in an insulated state from the external electrode;
container internal gas introducing means for introducing the container internal gas which is a source gas or a discharge gas to be generated as a plasma into the inside of the plastic container;
container external gas introducing means for introducing the container external gas which is a source gas or a discharge gas to be generated as a plasma into a sealed space which is the free space; and
high frequency supply means for supplying a high frequency to the external electrode.

2. A plasma CVD film forming apparatus, **characterized by** comprising:
an external electrode having a hollow shape with bottom having a free space for accommodating a plastic container and having an opening in the vicinity of a mouth part of the plastic container when the plastic container is accommodated;
an internal electrode removably disposed at the inside of the plastic container;
a cover having a mouth part opening for causing a mouth part of the plastic container to be abutted in an intimate contact state and via an insulating body such that a container internal gas and a container external gas of the plastic container are not mixed with each other when the plastic container is accommodated in the free space, the cover supporting the internal electrode such that the internal electrode is in an insulated state from the external electrode and the internal electrode passes through the mouth part opening, and further sealing the opening to form the free space as a sealed space;
container internal gas introducing means for introducing the container internal gas which is a source gas or a discharge gas to be generated as a plasma into the inside of the plastic container;
container external gas introducing means for introducing the container external gas which is a source gas or a discharge gas to be generated as a plasma into the sealed space formed of the external electrode and the cover; and
high frequency supply means for supplying a high frequency to the external electrode.

3. A plasma CVD film forming apparatus according to claim 1 or 2, **characterized in that** the free space of the external electrode is formed in a shape having a portion spaced from an outer surface of the plastic container when the plastic container is accommodated.

4. A plasma CVD film forming apparatus according to claim 1, 2, or 3, **characterized in that** the free space of the external electrode is formed in a shape having an inner wall face which comes into contact along a shape of a bottom part of the plastic container when the plastic container is accommodated.

5. A plasma CVD film forming apparatus according to claim 1, 2, or 3, **characterized in that** the free space of the external electrode is formed in a shape having an inner wall face which comes into contact along shapes of a bottom part and a body part of the plastic container when the plastic container is accommodated.

6. A plasma CVD film forming apparatus according to claim 1, 2, 3, 4, or 5, **characterized in that** the inner wall face of the external electrode which comes into contact along the shape of the bottom part of the plastic container or the inner wall face of the external electrode which comes into contact along shapes of the bottom part and body part of the plastic container is established in an insulated state from the high frequency supply means.

7. A plasma CVD film forming apparatus according to claim 1, 2, or 3, **characterized in that** a plastic container support base comprising an insulating body which comes into contact along the shape of the bottom part of the plastic container or the shapes of the bottom part and body part of the plastic container is installed at the inside of the free space.

8. A plasma CVD film forming apparatus according to claim 1, 2, 3, 4, 5, 6, or 7, **characterized in that** magnetic field generating means such as an inductive coil or a permanent magnet is peripherally provided on an outer wall face of the external electrode.

9. A plasma CVD film forming apparatus according to claim 1, 2, 3, 4, 5, 6, 7, or 8, **characterized in that** the free space of the external electrode is formed in a shape having a space with a size capable of accommodating a plurality of plastic containers at the same time, the cover supports the internal electrode disposed at every plastic container, and the internal gas introducing means introduces the internal gas in every plastic container.

10. A method for manufacturing a CVD film coated plastic container, **characterized by** comprising the steps of:
in a state in which a container internal gas and a container external gas of a plastic container are not mixed with each other, accommodating the plastic container in a free space of an external electrode compatible with a vacuum chamber and disposing an internal electrode at the inside of the plastic container;
replacing the inside of the plastic container with a source gas and replacing the inside of the free space with a discharge gas; and
supplying a high frequency to the external electrode, generating the source gas and the discharge gas as plasmas to form a CVD film on an inner surface of the plastic container, and carrying out plasma surface modifying such as static electricity prevention of an outer surface of the plastic container or improvement of applicability to outer face printing.

11. A method for manufacturing a CVD film coated plastic container, **characterized by** comprising the steps of:
accommodating a plastic container in a free space of an external electrode having a hollow shape with bottom, and abutting a mouth part of the plastic container with a mouth part opening provided at a cover for sealing an opening of the external electrode in an intimate contact state such that a container external gas and a container internal gas are not mixed with each other, thereby forming a sealed space with the external electrode and the cover;
replacing the inside of the plastic container with a source gas and replacing the inside of the sealed space with a discharge gas; and
supplying a high frequency to the external electrode, generating the source gas and the discharge gas as plasmas to form a CVD film on an inner surface of the plastic container and carrying out plasma surface modifying such as prevention of static electricity on an outer surface of the plastic container or improvement of applicability to outer face printing.

12. A method for manufacturing a CVD film coated plastic container, **characterized by** comprising the steps of:
in a state in which a container internal gas and a container external gas of a plastic container are not mixed with each other, accommodating the plastic container in a free space of an external electrode compatible with a vacuum chamber and disposing an internal electrode at the inside of the plastic container;
replacing the inside of the plastic container with a discharge gas and replacing the inside of the free space with a source gas; and
supplying a high frequency to the external electrode, generating the discharge gas and the source gas as plasmas to form a CVD film on an outer surface of the plastic container and carrying out plasma surface modifying such as sterilization of an inner surface of the plastic container or improvement of wetting properties.

13. A method for manufacturing a CVD film coated plastic container, **characterized by** comprising the steps of:
accommodating a plastic container in a free space of an external electrode having a hollow shape with bottom, abutting a mouth part of the plastic container with a mouth part opening provided at a cover for sealing an opening of the external electrode in an intimate contact state such that a container external gas and a container internal gas are not mixed with each other and disposing an internal electrode at the inside of the plastic container to form a sealed space with the external electrode and the cover;
replacing the inside of the plastic container with a discharge gas and replacing the inside of the sealed space with a source gas; and
supplying a high frequency to the external electrode, generating the discharge gas and the source gas as plasmas to form a CVD film on an outer surface of the plastic container and carrying out plasma surface modifying such as sterilization of an inner surface of the plastic container or improvement of wetting properties.

14. A method for manufacturing a CVD film coated plastic container, **characterized by** comprising the steps of:
in a state in which a container internal gas and a container external gas of a plastic container are not mixed with each other, accommodating the plastic container in a free space of an external electrode compatible with a vacuum chamber and disposing an internal electrode at the inside of the plastic container;
replacing the inside of the plastic container and the inside of the free space with a source gas; and
supplying a high frequency to the external electrode and generating the source gas as a plasma to form CVD films on an inner surface and an outer surface of the plastic container at the same time.

15. A method for manufacturing a CVD film coated plastic container, **characterized by** comprising the steps of:
accommodating a plastic container in a free space of an external electrode having a hollow shape with bottom, abutting a mouth part of the plastic container with a mouth part opening provided at a cover for sealing an opening of the external electrode in an intimate contact state such that a container external gas and a container internal gas are not mixed with each other and disposing an internal electrode at the inside of the plastic container to form a sealed space with the external electrode and the cover;
replacing the inside of the plastic container and the inside of the sealed space with a source gas; and
supplying a high frequency to the external electrode and generating the source gas as a plasma to form CVD films on an inner surface and an outer surface of the plastic container at the same time.

16. A method for manufacturing a CVD film coated plastic container according to claim 10, 11, 12, 13, 14, or 15, **characterized in that**, when a high frequency is supplied to the external electrode, a bottom part of the plastic container receives a high frequency from an inner wall face of the external electrode which comes into contact along a shape of the bottom part to generate a self bias voltage, and a neck part, a shoulder part, and a body part of the plastic container receive a high frequency when the container external gas generated as a plasma is defined as an electrically conducting body to generate a self bias voltage and to ignite plasmas as fires at the inside and outside of the plastic container.

17. A method for manufacturing a CVD film coated plastic container according to claim 10, 11, 12, 13, 14, or 15, **characterized in that**, when a high frequency is supplied to the external electrode, a bottom part and a body part of the plastic container receive a high frequency from an inner wall face of the external electrode which comes into contact along shapes of the bottom part and body part to generate a self bias voltage, and a neck part and a shoulder part of the plastic container receive a high frequency when the container external gas is defined as an electrically conducting body to generate a self bias voltage and to ignite plasmas as fires at the inside and outside of the plastic container.

18. A method for manufacturing a CVD film coated plastic container according to claim 10, 11, 12, 13, 14, or 15, **characterized in that**, an inner wall face of the external electrode which comes into contact along a shape of a bottom part of the plastic container or an internal wall face of the external electrode which comes into contact along shapes of the bottom part and body part of the plastic container is established in an insulated state from a high frequency.

19. A method for manufacturing a CVD film coated plastic container according to claim 10, 11, 12, 13, 14, or 15, **characterized in that** an insulating body coming into contact along a shape of a bottom part of the plastic container or shapes of the bottom part and body part of the plastic container is installed at the inside of the free space, and the bottom part of the plastic container or the bottom part and body part of the plastic container are established in an insulated state from a high frequency.

20. A method for manufacturing a CVD film coated plastic container according to claim 10, 11, 12, 13, 14, 15, 16, 17, 18, or 19, **characterized by** comprising the steps of:
in a state in which a container internal gas and a container external gas of a plastic container are not mixed with each other, accommodating a plurality of plastic containers in a free space of an external electrode compatible with a vacuum chamber and disposing an internal electrode at the inside of the each plastic containers;
replacing the inside of the each plastic container with a container internal gas which is a source gas or a discharge gas and replacing the free space with a container external gas which is a source gas or a discharge gas; and
supplying a high frequency to the external electrode and generating the container internal gas and the container external gas as plasmas to form CVD films on at least either of inner surfaces and outer surfaces of the plurality of plastic containers at the same time.

21. A method for manufacturing a CVD film coated plastic container according to claim 10, 11, 12, 13, 14, 15, 16, 17, 18, or 19, **characterized by** comprising the steps of:
accommodating a plurality of plastic containers in a free space of an external electrode having a hollow shape with bottom, abutting a mouth part of the each plastic container with each of a plurality of mouth part openings provided at a cover for sealing an opening of the external electrode in an intimate contact state such that a container external gas and a container internal gas are not mixed with each other and disposing an internal electrode at the inside of each of the plastic containers to form a sealed space with the external electrode and the cover;
replacing the inside of the each plastic container with a container internal gas which is a source gas or a discharge gas and replacing the sealed space with a container external gas which is a source gas or a discharge gas;
supplying a high frequency to the external electrode, and generating the container internal gas and the container external gas as plasmas to form CVD films on at least either of inner surfaces and outer surfaces of the plurality of plastic containers at the same time.

22. A method for manufacturing a CVD film coated plastic container according to claim 10, 11, 12, 13, 14, 15, 16, 17, 18, 19, 20, or 21, **characterized in that** a hydrocarbon based gas or a Si-containing hydrocarbon based source gas is used as the source gas to form a DLC (Diamond Like Carbon) film as a CVD film.
